# EUROPEAN PATENT SPECIFICATION

(11) **EP 1 518 232 B1**
(45) Date of publication and mention of the grant of the patent: **17.05.2006**
(21) Application number: 03735633.4
(22) Date of filing: 16.06.2003
(51) Int. Cl.: G11B 7/125, H01S 5/0683, H01S 5/40

(54) **INTRINSICALLY SAFE PICK-UP FOR REPRODUCTION OR RECORDING DEVICES FOR DIFFERENT OPTICAL RECORDING MEDIA**
EIGENSICHERER ABTASTKOPF FÜR WIEDERGABE- ODER AUFNAHMEGERÄTE FÜR VERSCHIEDENE OPTISCHE SPEICHERMEDIEN
CAPTEUR A SECURITE INTRINSEQUE POUR DISPOSITIFS DE LECTURE OU D'ENREGISTREMENT DE DIFFERENTS SUPPORTS D'ENREGISTREMENT OPTIQUES

(30) Priority: 28.06.2002 DE 10229234
(43) Date of publication of application: 30.03.2005
(73) Proprietor: Thomson Licensing, 92100 Boulogne-Billancourt (FR)
(72) Inventor: ZUCKER, Friedhelm, 78052 Villingen-Schwenningen (DE)
(74) Representative: Kurth, Dieter
(86) International application number: PCT/EP2003/006342
(87) International publication number: WO 2004/003900

(56) References cited:
- EP-A- 1 005 121
- EP-A- 1 067 529
- EP-A- 1 170 840
- WO-A-03/050808
- US-B1- 6 295 260
- PATENT ABSTRACTS OF JAPAN vol. 1998, no. 13, 30 November 1998 (1998-11-30) -& JP 10 209545 A (FUJI XEROX CO LTD), 7 August 1998 (1998-08-07)

## Description

The invention relates to an intrinsically safe pick-up for reproduction or recording devices for different optical recording media, which have at least two lasers with a monitor diode which is used in cooperation with both lasers, such as a monitor diode which is integrated in a twin laser, and which devices are provided for different recording media, such as DVD and CD recording media.

Optical recording media, such as CD, DVD or Blue Disc, differ in terms of their storage density, structure, layer construction and size of the information storage elements. Recording and reproducing information on such different recording media requires not only a light source that is matched to the respective recording media but also detectors whose sensitivities have to be adjusted in order to control the light power of the light sources. A twin laser is already known as a light source, which is connected to a modulator for providing the light, which is required for recording or reproducing different recording media. Twin lasers such as these are generally equipped with a photodiode, a so-called monitor diode, which is provided as an integrated component of the twin laser and is used as a photodetector in order to control the light power of the lasers. At least two different light sources, or different light power levels at the pick-up, then have to be controlled or regulated by means of one monitor diode.

In consequence, switching means and switching signals must be provided, by means of which the sensitivity of the photodetector or of a downstream processing circuit is matched to the respective light power level, and the light power of the lasers or laser diodes is regulated.

Integrated DVD/CD circuits for reproduction or recording devices for different optical recording media are based on the use of two independent lasers, each having a monitor diode, and contain two current sources for controlling the light power of the laser diodes, which are controled dependent on the type of recording medium. For this purpose, the circuits have a disc type identification circuit, which generates appropriate control signals. However, it has been found that the disc type identification is difficult and both lasers are driven at the same time which, causes an incorrect association between the light power adjusting resistors and the appropriate laser, which overloads and destroys the twin laser. On the other hand, the data sheet for a modulator circuit for twin lasers refers to a circuit arrangement having an additional changeover switch, which prevents the two lasers from being driven at the same time, and thus ensures compatibility with the previous pick-ups. However, this has the disadvantage that it requires an additional changeover switch, which needs to be controlled in a manner that is not stated there. The cited data sheet likewise does not contain any information relating to the control of the sensitivity of the photodetector or of a downstream processing circuit.

A pickup having at least two laser diodes and having a monitor diode, which controls different light power levels of the laser diodes is already known from EP-A1-1 170 840 (c.f the preamble of claim 1) and interlocked controlled switches are known from EP-A2- 1 005 1221. Furthermore, an optical disk type recognizing circuit for generating an optical disk recognition signal including information representing whether the optical disk loaded on the optical disk loader is a writeable optical disk or a read only disk optical disk has been disclosed according to US-B1- 6 295 260.

It is an object of the invention to provide an intrinsically safe pick-up for reproduction or recording devices having a twin laser and a small number of switching elements and control lines, which contains a monitor diode to control the light power of the two lasers, but which nevertheless ensures reliable operation, and prevents destruction of the twin laser, without any additional changeover switch.

This object is achieved by the features specified in the independent claim. Advantageous embodiments are specified in dependent claims.

It is an aspect of the invention to design the pick-up of a reproduction or recording device for different optical recording media as an intrinsically safe product having a twin laser which contains a monitor diode to control the light power of the two lasers, such that there is no need for an additional changeover switch in order to drive the laser diodes separately, and correct association is ensured between a light power adjusting resistor and the corresponding laser.

According to a further aspect of the invention, a reproduction or recording device for different optical recording media is proposed, having an intrinsically safe pick-up which involves little complexity and only a small number of connecting lines between the intrinsically safe pick-up and a DVD/CD circuit.

Since one aim is to control the light power of two laser diodes using only one monitor diode, and another aim is not to use an additional changeover switch to guarantee that the two laser diodes of the twin laser are driven separately, an intrinsically safe pick-up is provided which prevents destruction of the twin laser when the two laser diodes are driven simultaneously, and ensures that the light power adjusting resistors are associated correctly with the appropriate laser, without any additional changeover switch. For this purpose, the intrinsically save pick-up comprises a switching means, which is formed by interlocked switches by means of which reference values are produced in order to control the light power of the lasers in the twin laser, and by means of which the intrinsic safety of the pick-up is produced. The intrinsic safety of the pick-up is formed by simultaneous driving of the lasers in a reproduction or recording device for different optical recording media with a common used monitor diode, not leading to overloading or destruction of the lasers. The switching means, which is formed with interlocked switches, is for this purpose provided such that, when one laser is driven, the only light power adjusting means which is connected to the monitor diode is that which is provided in order to form a reference value which is associated with this laser, and one light power adjusting means is effective when both lasers are driven, so as to prevent overloading or destruction of the lasers. The light power adjusting means which prevents overloading or destruction of the lasers when they are driven at the same time is provided in such a way as to ensure that the light power adjusting means, which are provided with the monitor diode in order to form the reference values for the lasers, are switched off.

According to one exemplary embodiment, a switching means which is formed with interlocked switches is provided such that, when both switches are actuated at the same time, both switches are made to open by inserting a logic circuit in the control line for the switches. The logic circuit is formed, for example, by in an AND gate, arranged in each line and which has an inverting input which is connected to the control line of the other switch. Fundamentally, this principle can also be extended to more than two lasers whose different light powers are intended to be controlled by only one monitor diode. In an embodiment such as this, AND gates having an appropriate number of inverting inputs must be provided or, when using AND gates with only one inverting input, appropriate decoupling diodes must be provided.

The light power adjusting means are potentiometers or adjusting regulators which are connected to a reference of the laser regulators and are connected via the interlocked switches to the monitor diode, which generates the input signal for adjusting the light power by means of laser regulators. The reference of the laser regulators is, for example, a ground point in the DVD/CD circuit which forms the laser driver board, since the ground potential for the pick-up is generally not the same as that of the laser driver board. In principle, it is also possible to arrange the light power adjusting means upstream of the switches, so that they are connected to the reference for the laser regulators via the switches. A signal which is generated by a modulator and provided for one laser is preferably used as the control signal for the switches. In principle, the control signals for the switches for the switching means may also be formed by comparators which are connected to the lasers and are used as threshold value switches.

For a twin laser, which contains two lasers with a shared monitor diode, two modulators are provided in one modulator assembly, since the light which is generated by the lasers of the twin laser is not sufficiently uniform to allow one of them to be used for recording or reproducing information to or from optical recording media. One modulator is connected to each laser, and is switched on when that laser is driven. In addition to the frequency and amplitude of the modulation signal, this results in a switching signal which, according to one aspect of the invention, is used as a switching signal for controlling the switching means. Since the switches for the switching means connect different light power adjusting means to the monitor diode, a photodetector is formed whose sensitivity is used to control the light power of the lasers. The sensitivity of the photodetector is used to generate a reference value, which is used to control the light power of the laser or of the laser diode. The sensitivity of the photodetector and the reference value which is associated with a laser diode are produced by connecting an appropriate resistor in parallel with the monitor diode which generates the control signal for the laser regulator. Since different light power levels and different reference values can be set using only one monitor diode, a corresponding number of resistors are provided, which form light power adjusting resistors and are in the form of potentiometers or adjusting regulators in order to set a predetermined light power level. Since incorrect association of the light power adjusting resistors with the appropriate laser or simultaneous connection of both light power adjusting resistors in the case of a twin laser leads to its overloading and destruction, the abovementioned switching means is provided such that, in accordance with one embodiment of the invention, it is arranged together with the modulator assembly on a substrate. The modulator assembly contains a separate modulator for each of the laser diodes, and the switches are in the form of electronic switches. The described arrangement results in an intrinsically safe pick-up whose lasers are not overloaded or destroyed even if they are driven simultaneously, so that there is no need for any additional changeover switch to drive the lasers separately, while nevertheless providing compatibility with previous pickups. A DVD/CD circuit with two separate current sources for controlling the light power of the laser diodes in the twin laser is then used to form, with little complexity, a reproduction or recording device for different optical recording media, which is highly reliable owing to the use of an intrinsically safe pick-up, and which requires only a small number of connecting lines between the pick-up and a DVD/CD circuit.

The intrinsic safety of the pick-up is achieved in that a photodetector, which has the greatest sensitivity, is formed by the monitor diode while the lasers of the twin laser are driven simultaneously. The high sensitivity of the photodetector results in the laser power of the lasers being reduced, thus preventing overloading or destruction of the twin laser. The high sensitivity of the photodetector that is formed by the monitor diode is achieved by switching off the light power adjusting resistors, or the light power adjusting means, which are provided in order to adjust the sensitivity of the photodetectors, when a further laser is driven in addition to one laser. Correct association between a light power adjusting means and the corresponding laser is ensured by using the laser current to drive the appropriate switch. The intrinsic safety of the pick-up that is achieved in this way, advantageously means that there is no longer any need for an additional changeover switch, which was provided between a DVD/CD circuit and a pick-up in order to guarantee that the lasers were driven simultaneously.

The invention will be explained in more detail in the following text with reference to exemplary embodiments in the drawings, in which:
- Figure 1: shows a block diagram of a circuit arrangement of a reproduction or recording device for different optical recording media having an intrinsically safe pick-up,
- Figure 2: shows a truth table relating to the intrinsic safety of the pick-up,
- Figure 3: shows a block diagram of a circuit arrangement for producing control signals for switches for a switching means for producing reference values for different light powers of a twin lasers with one monitor diode,
- Figure 4: shows a block diagram of a circuit arrangement of a reproduction or recording device for different optical recording media with a known pick-up,

- Figure 5: shows a block diagram of a laser diode modulator,
- Figure 6: shows a block diagram of a circuit arrangement of a reproduction or recording device for different optical recording media, in each case having a separate monitor diode for each laser, and
- Figure 7: shows a block diagram of a circuit arrangement of a reproduction or recording device for different optical recording media, having a pick-up that is not safe.

The reference symbols used in the figures match one another.

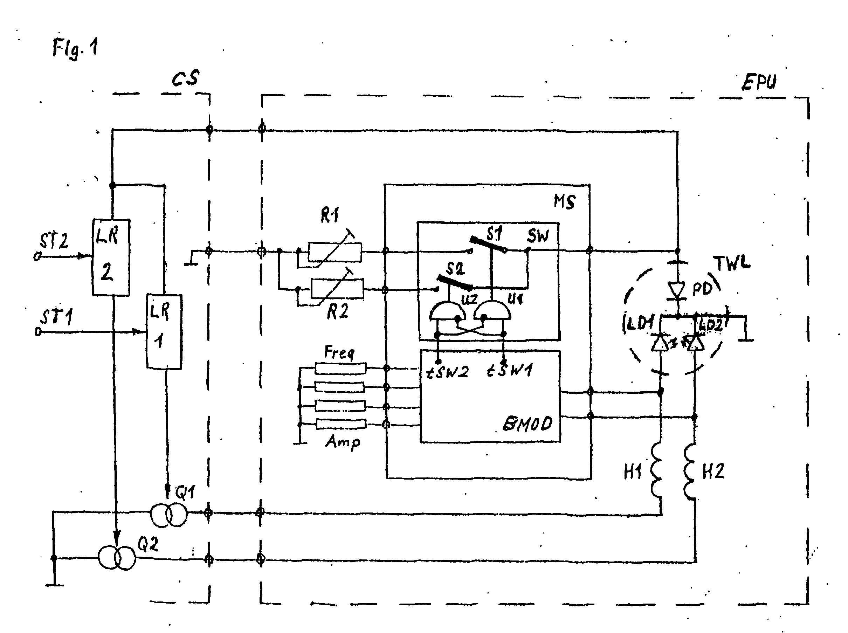

Figure 1 shows the block diagram of a reproduction or recording device for different optical recording media with an intrinsically safe pick-up EPU, which has been reduced to the elements that are essential for the purposes of the invention, for reasons of clarity. The reproduction or recording device for different optical recording media is formed with an integrated DVD/CD circuit CS, to which an intrinsically safe pick-up EPU is connected via only a small number of lines and without an additional changeover switch.

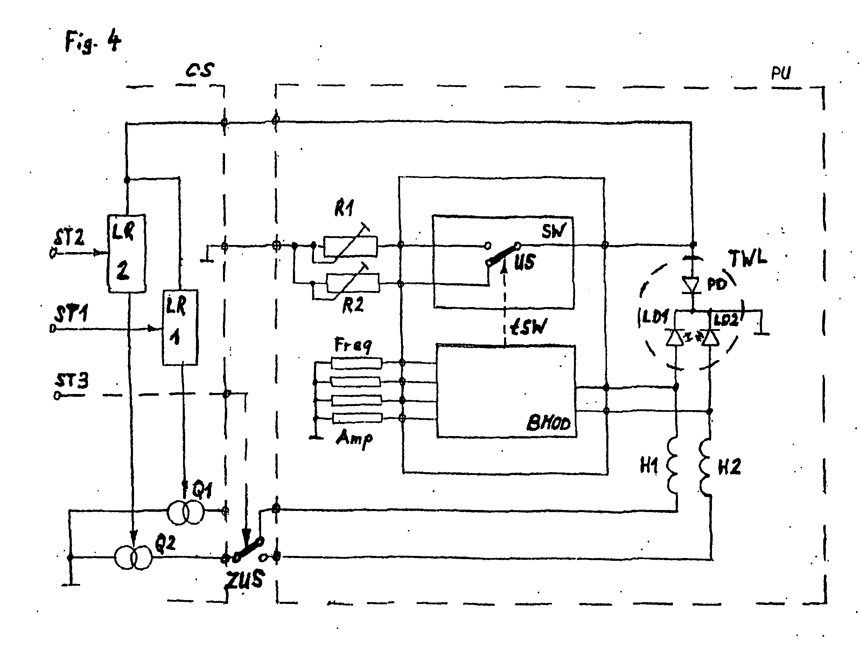

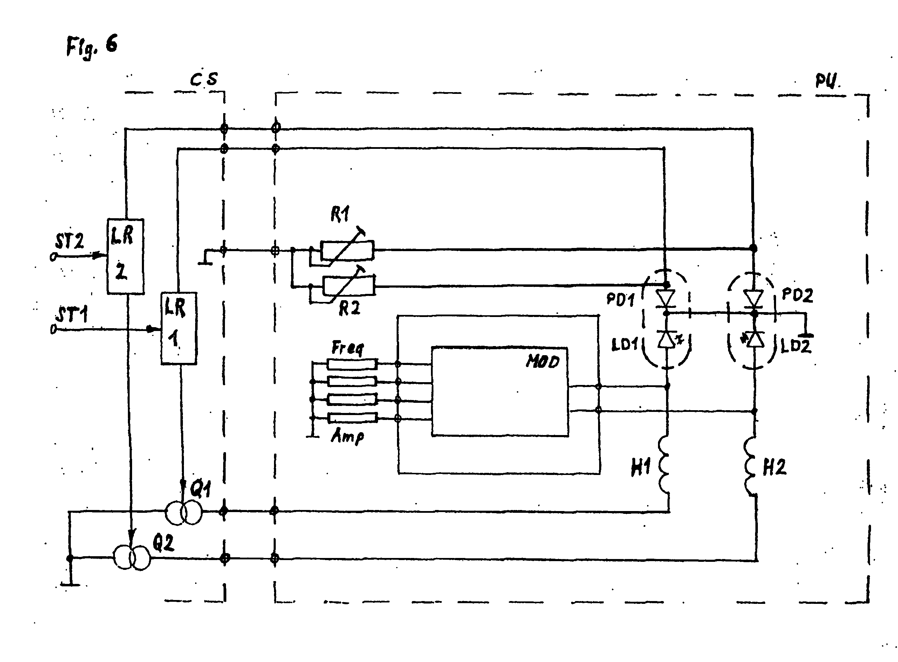

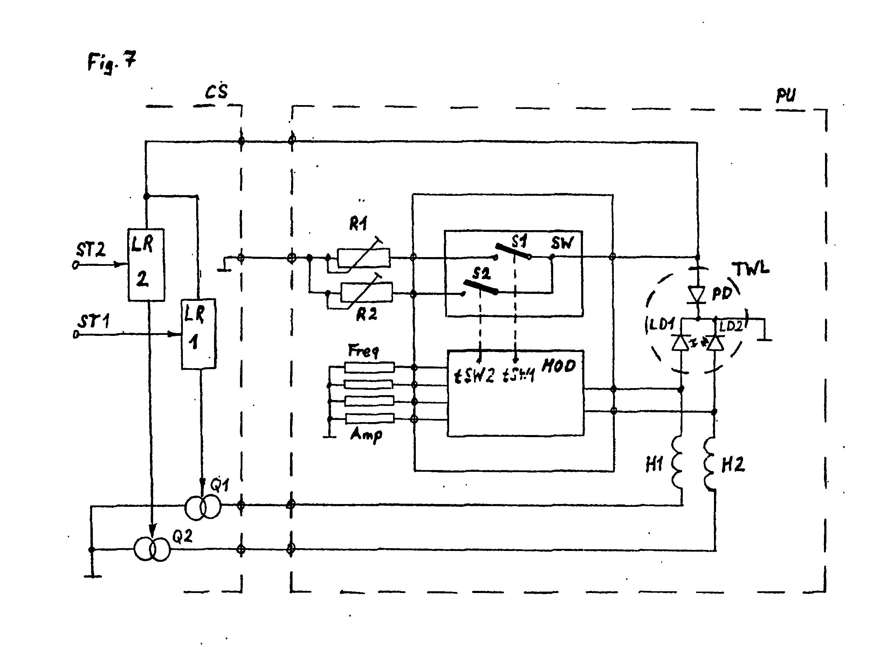

As is shown in Figure 6, the development of integrated DVD/CD circuits CS for reproduction or recording devices for different optical recording media has been based on the use of two laser diodes LD1, LD2, each having a monitor diode PD1, PD2, which each form an optical system for recording or reproducing information for different optical recording media. This has led, as standard, to integrated DVD/CD circuits CS having two laser regulators LR1, LR2 and two current sources Q1, Q2, which were intended for a pick-up PU with two laser diodes LD1, LD2 each having a respective monitor diode PD1, PD2. The light powers of the lasers LD1, LD2 were in consequence regulated independently of one another, by means of a respective laser control loop. A reference value for the light power in the respective laser control loop was formed in each laser control loop, separately by means of a respective light power adjusting resistor R1 or R2 connected to the respective monitor diode PD1 or PD2. Since two separate laser control loops, each having a monitor diode PD1 or PD2, were used, mutual interference between or incorrect association of the light power adjusting resistors R1 and R2 was fundamentally impossible. A pick-up PU such as this with two separate optical systems was generally regarded as being reliable. However, such pick-ups PU had the disadvantage that they were highly complex, since separate optical systems were required. The size of the laser diodes LD1, LD2 with their monitor diodes PD1, PD2 and the physical separation between the lasers LD1, LD2 in principle necessitated two optical systems for the different recording media. With the development of so-called twin lasers TWL, which combine two laser diodes LD1, LD2 and a monitor diode PD a short distance apart from one another on one chip, it was possible to significantly reduce the number of optical systems, and hence the complexity. A circuit arrangement in which the two lasers LD1, LD2 with separate monitor diodes PD1, PD2 are replaced by a twin laser TWL, is shown in Figure 7. Since the twin lasers TWL has only one monitor diode PD, by means of which the light power of the lasers LD1, LD2 can be controlled for different optical recording media, a switching means SW must be provided, which is used to set an appropriate reference value for the respective laser LD1, LD2. This switching means SW could be arranged on a printed circuit board on which the DVD/CD circuit CS is also arranged. However, a solution has already been illustrated in Figure 7, which advantageously uses one switching signal tSW for the switching means SW, with this switching signal tSW being produced by modulators MOD for the laser diodes LD1, LD2. However, regardless of whether the switches S1, S2 of the switching means SW are driven directly by a switching signal tSW from the modulators MOD or directly by a disc type identification signal from the DVD/CD circuit CS, a pick-up PU such as this is not safe and is unreliable. This is due to the fact that control signals ST1, ST2 which are produced by a disc type identification circuit (which is not illustrated) and are intended to be used to switch on the appropriate laser LD1, LD2 for the appropriate disc type DVD or CD frequently occur jointly and result in the two lasers LD1 and LD2 in the twin laser TWL being driven simultaneously. Simultaneous driving of both lasers LD1, LD2 or incorrect association of a light power adjusting resistor R1, R2 with the laser LD1 or LD2 leads to overloading or to destruction of the twin laser TWL, since the photodetector which is formed by the monitor diode PD has its lowest sensitivity when the light power adjusting resistors R1, R2 are connected in parallel, which leads in the laser control loop to overdriving of the lasers LD1, LD2 and/or to destruction of the lasers LD1, LD2. This also applies to incorrect association of a light power adjusting resistor R1, R2 with the lasers LD1, LD2, as occurs, for example, when both lasers LD1, LD2 are driven, only one of the light power adjusting resistors R1, R2 is connected to the monitor diode PD, and the laser regulator LR1, LR2 which generates the higher laser current is providing the control action. This can be caused not only by the light power adjusting resistor R1, R2 which sets the lower sensitivity of the photodetector, but also by a different offset between the inputs of the laser regulators LR1, LR2. Since even the replacement of the switches S1, S2 (which are illustrated in Figure 7) of the switching means SW by a changeover switch US, as is illustrated in Figure 4, does not preclude overloading or destruction of the twin laser TWL, the use of an additional changeover switch ZUS has already been proposed in a data sheet for modulators for twin lasers TWL. An additional changeover switch ZUS in the connecting lines of the lasers LD1, LD2, as is illustrated in Figure 4, ensures that only one laser LD1 or LD2 is driven. The additional changeover switch ZUS represents increased complexity and requires a control signal ST3, which must be produced additionally by a combination of the control signals ST1 and ST2.

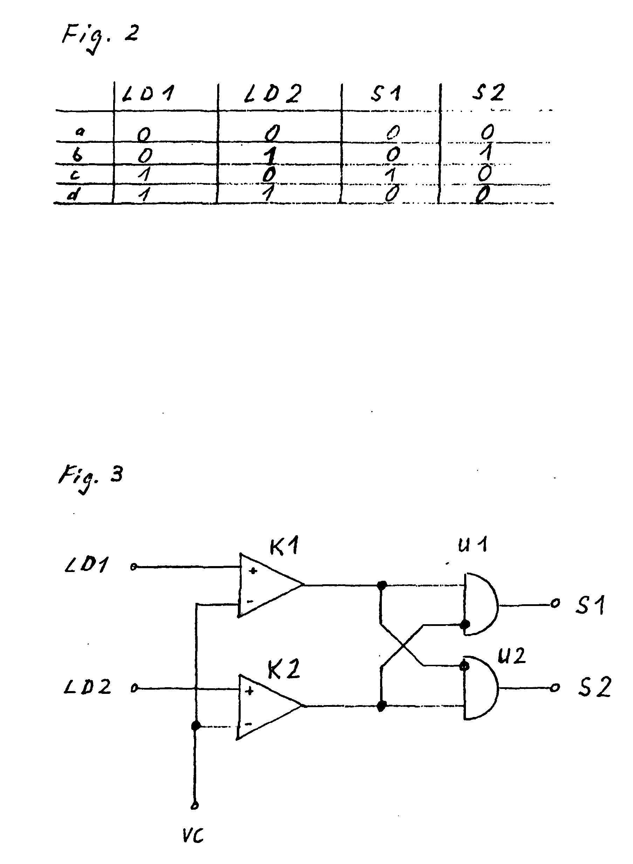

Although, initially, it appeared to be impossible to dispense with the additional changeover switch ZUS, which is also mentioned in data sheets from manufacturers for modulators for twin lasers TWL, one object of the invention was to provide an intrinsically safe pick-up EPU with a twin laser TWL even without the additional changeover switch ZUS, allowing the reproduction or recording devices of different optical recording media to be produced with a low level of complexity. An exemplary embodiment of a device such as this with an intrinsically safe pick-up EPU is illustrated in Figure 1. The invention is based on the knowledge that it is necessary to preclude destruction or overloading of the twin laser TWL by simultaneously driving the lasers LD1, LD2 or by incorrectly associating a light power resistor R1, R2 as a result of unreliable disc type identification. For this purpose, as shown in Figure 1, a switching means SW is provided, which is formed with interlocked switches S1, S2 which produce only one reference value for one of the lasers LD1 or LD2. The interlocking of the switches S1, S2 is achieved, in principle, by connecting only one light power adjusting resistor R1 or R2 via the switches S1, S2 to the monitor diode PD, with the two light power adjusting resistors R1, R2 being isolated from the monitor diode when the lasers LD1, LD2 are driven simultaneously. With a light power adjusting resistor R1 or R2, the monitor diode PD forms a photodetector of predetermined sensitivity, which is used to produce a reference value for controlling the light power of the corresponding laser LD1, LD2. Since the light power adjusting resistors R1, R2 are isolated from the monitor diode PD when the lasers LD1, LD2 are driven simultaneously, this results in a very high sensitivity photodetector, so that the light power of the lasers LD1, LD2 is reduced by the laser regulators LR1, LR2, thus preventing overloading and/or destruction of the twin laser TWL. Based on this knowledge, it has been possible to produce a truth table as illustrated in Figure 2, which characterizes the switching states of the switches S1, S2 for the switching means SW as a function of the drive state of the lasers LD1, LD2, as indicated by a to d. In the table shown in Figure 2, a zero 0 indicates that the corresponding laser LD1, LD2 is not being driven and the corresponding switch S1, S2 is open. A one 1 indicates that the corresponding laser LD1, LD2 is being driven, or that the corresponding switch S1, S2 is closed. It should be noted that, in the situation when neither of the lasers LD1, LD2 is being driven, it is irrelevant whether the switches S1, S2 are open or closed.

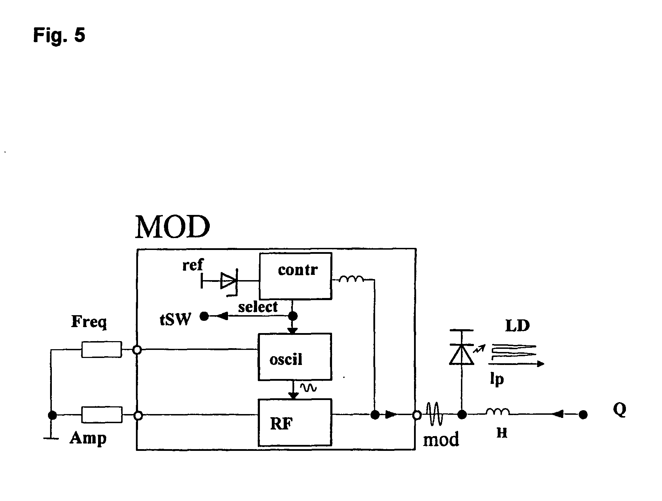

Based on the abovementioned truth table, a circuit arrangement can then be formed, one embodiment of which is illustrated in Figure 3. Based on Figure 3, two comparators K1, K2 are provided, and are connected to a respective laser LD1 or LD2. The comparators K1, K2, which on the other hand are connected to a reference voltage source VC, are used to produce switching signals for a logic circuit, which is used to control the switches S1, S2 for the switching means SW. The logic circuit comprises two AND gates U1, U2 which each have an inverting input, which is in each case connected to the non-inverting input of the other AND gate U1, U2. The outputs of the AND gates U1, U2 then produce control signals for the switches S1, S2 for the switching means SW in accordance with the truth table illustrated in Figure 2. However, there is no need for the comparators K1, K2 illustrated in Figure 3 if, as illustrated in Figure 1, switching signals tSW1, tSW2 from the modulator assembly BMOD are used for controlling the logic circuit mentioned above. The modulator assembly BMOD contains a modulator MOD for each of the lasers LD1, LD2, whose fundamental design is shown in a block diagram in Figure 5.

The modulator MOD which is shown in Figure 5 is connected to that connection of a laser LD which is connected via an inductor H to a current source Q that is provided as a laser driver. The modulator MOD is switched on via this connection to the laser LD, which is also used to supply the laser LD with a modulator signal mod that is produced by the modulator MOD. The modulation signal mod is a radio-frequency signal of predetermined amplitude, which is used to produce a modulated light power Lp which is characterized, in a known manner, by greater uniformity than is required for recording or reproducing information using optical recording media. When a twin laser TWL is used, this modulation must also be provided for the laser LD1 or LD2 which is intended for the CD recording medium. The modulator MOD contains an oscillator oscil and an amplifier RF, to which a resistor Freq and a resistor Amp are connected in order to set the frequency and amplitude of the modulation signal mod.

A control assembly contr is provided in order to switch on the modulator MOD and is used to produce a switching signal tSW by comparison with a reference voltage ref, analogously to the comparators K1, K2 illustrated in Figure 3. In order to make it possible to use this switching signal tSW, it is proposed that a connection select be provided on the modulator MOD, at which a switching signal tSW is produced which is suitable for use as an input signal for the logic circuit mentioned above. Two or more such modulators MOD are then joined together, as illustrated in Figure 1, to form a modulator assembly BMOD.

Other exemplary embodiments, which are not illustrated, provide for the logic circuit to be integrated in the modulator assembly BMOD, as well as for the switching means SW to be arranged on a common substrate MS with the logic circuit and the modulator assembly BMOD. The switches S1, S2 for the switching means are then in the form of electronic switches S1, S2.

As illustrated in Figure 1, switching signals tSW1, tSW2 which are produced by the modulator assembly BMOD, an intrinsically safe pick-up EPU and a DVD/CD circuit CS are used to provide a recording or reproduction device for different optical recording media, which involves little complexity and requires only a small number of connecting lines between the intrinsically safe pick-up EPU and the DVD/CD circuit CS. There is no need for an additional changeover switch ZUS, since the intrinsically safe pick-up EPU ensures that, despite the laser regulators LR1, LR2 being driven by control signals ST1, ST2 (which are produced at the same time by a disc type identification circuit) at the same time, the twin laser TWL is neither overloaded nor destroyed.

Correct association between the light power adjusting resistors R1, R2 and the corresponding lasers LD1, LD2 is ensured by using the control current for the lasers LD1, LD2 to control the switches S1, S2 for the switching means SW.

The monitor diodes PD, which are illustrated in the figures, are monitor diodes PD with a common cathode, which means that the cathode of the monitor diode PD is connected to the laser diode or diodes LD1, LD2. The advantage of monitor diodes PD with a common cathode is that there is no need for a negative supply voltage for the laser driver.

As is illustrated in Figure 1, two laser diodes LD1, LD2 are integrated jointly with a monitor diode PD, as a twin laser TWL, in an assembly in which the laser diodes LD1, LD2 and the monitor diode PD are connected to one another via a common ground line. The production of a photodetector signal which is independent of the absolute light power level of the laser diodes LD1, LD2 is envisaged in order to make it possible to control the light power of both laser diodes LD1, LD2 using relatively simple amplifiers or laser regulators LR1, LR2. Driver stages or current sources Q1, Q2, to which the laser diodes LD1, LD2 are connected via induction coils H1, H2, are provided in order to set different currents for the laser diodes LD1, LD2. One or other of the laser diodes LD1, LD2 is then driven in accordance with the respective requirements for the recording medium. The light power levels produced by the laser diodes LD1, LD2 differ such that a signal which is produced by the monitor diode PD is also subject to corresponding differences. In order nevertheless to produce a photodetector signal which is independent of the absolute light power level of the laser diodes LD1, LD2, the monitor diode PD is connected via the switching means SW to light power adjusting resistors R1, R2. Together with the monitor diode PD, the light power adjusting resistors R1, R2 form a photodetector, whose sensitivity is controlled by the switching means SW. In this embodiment the different sensitivity of the photodetector is achieved in a corresponding manner by connecting different resistance values in parallel with the monitor diode PD. The output signal from the monitor diode PD is in consequence attenuated to different extents in order to produce a photodetector signal which is independent of the absolute light power level of the laser diodes LD1, LD2.

The intrinsically safe pick-up EPU has a switching means SW, which is formed with interlocked switches S1, S2 and is used not only to produce a reference value, which is associated with one laser diode LD1 or LD2 together with the monitor diode PD, for controlling the light power of the laser diode LD1 or LD2, but at the same time to prevent the laser diodes LD1, LD2 from being driven simultaneously or incorrect association of a light power adjusting means, leading to overloading or to destruction of the twin laser TWL. A reproduction or recording device which is produced with an intrinsically safe pick-up for different optical recording media does not require an additional changeover switch ZUS, which otherwise needs to be provided between a DVD/CD circuit CS and a pick-up with a twin laser TWL.

The embodiments described here are quoted as examples, and a person skilled in the art may also produce other embodiments of the invention, which remain within the scope of the invention.

## Claims

1. An intrinsically safe pick-up for reproduction or recording devices for different optical recording media having at least two laser diodes (LD1, LD2), a monitor diode (PD), switches (S1, S2) and resistors to control different light power levels of the laser diodes (LD1, LD2), **characterized in that**,
a switching means (SW) is provided, which is formed with interlocked switches (S1, S2) and comprises a logic circuit in order to generate a reference value which is associated with a laser diode (LD1 or LD2) and in order to form an intrinsically safe pick-up (EPU), whereby said logic circuit prevents simultaneous closure of the switches (S1, S2) and opens the switches (S1, S2) with simultaneous actuation.

2. An intrinsically safe pick-up according to claim 1, wherein the switching means (SW) comprises a logic circuit which is formed by two AND gates (U1, U2) each having an inverting input, and in which each inverting input of an AND gate (U1 or U2, respectively) is connected to the input of the other AND gate (U2 or U1, respectively), to which a switching signal (tSW1, tSW2) is applied for one of the switches (S1 or S2) of the switching means (SW), whose control intput is connected to the output of the AND gate (U1 or U2) to whose input the switching signal (tSW1, tSW2) for the switch (S1 or S2) is applied.

3. An intrinsically safe pick-up according to claim 1, wherein the switches (S1, S2) of the switching means are controlled via a logic circuit, which interlocks the switches (S1, S2) and forms an intrinsically safe pick-up (EPU), by means of switching signals (tSW1, tSW2) from a modulator assembly (BMOD) which is connected to the laser diodes (LD1 or LD2).

4. An intrinsically safe pick-up according to claim 3, wherein a modulator (MOD) is provided in the modulator assembly (BMOD) for each of the laser diodes (LD1 or LD2) and has a control assembly (contr) which switches on the modulator (MOD) when the laser diode (LD1, LD2) to which it is connected is actuated, and wherein the control assembly (contr) generates a switching signal (tSW) for controlling the switches (S1, S2) by means of the logic circuit.

5. An intrinsically safe pick-up according to claim 1, wherein the control inputs of the switches (S1, S2) of the switching means (SW) are connected to comparators (K1, K2) which are connected to the laser diodes (LD1 or LD2), via a logic circuit which interlocks the switches (S1, S2) and forms an intrinsically safe pick-up (EPU).

## Patentansprüche

1. Eigensicherer Pickup für Wiedergabe- oder Aufzeichnungsgeräte für unterschiedliche optische Aufzeichnungsträger mit wenigstens zwei Laserdioden (LD1, LD2) einer Monitordiode (PD), Schaltern (S1, S2) und Widerständen, um unterschiedliche Lichtleistungspegel der Laserdioden (LD1, LD2) zu steuern, **dadurch gekennzeichnet, dass** Schaltmittel (SW) vorgesehen sind, die durch verriegelte Schalter (S1, S2) gebildet sind und eine logische Schaltung umfassen, um einen Bezugswert zu erzeugen, der einer Laserdiode (LD1 oder LD2) zugeordnet ist, und um einen eigensicheren Pickup (EPU) zu bilden, wobei die logische Schaltung ein gleichzeitiges Schließen der Schalter (S1, S2) verhindert und die Schalter (S1, S2) bei gleichzeitiger Betätigung öffnet.

2. Eigensicherer Pickup nach Anspruch 1, bei dem die Schaltmittel (SW) eine logische Schaltung umfassen, die aus zwei UND-Gattern (U1, U2) gebildet ist, die jeweils einen invertierenden Eingang haben, und wobei der invertierende Eingang eines UND-Gatters (U1 bzw. U2) mit dem Eingang des anderen UND-Gatters (U1 bzw. U2) verbunden ist, dem ein Schaltsignal (tSW1, tSW2) für einen der Schalter (S1 oder S2) der Schaltmittel (SW) zugeführt wird, dessen Steuereingang mit dem Ausgang des UND-Gatters (U1 oder U2) verbunden ist, dessen Eingang das Schaltsignal (tSW1, tSW2) für den Schalter (S1 oder S2) zugeführt wird..

3. Eigensicherer Pickup nach Anspruch 1, bei dem die Schalter (S1, S2) der Schaltmittel über eine logische Schaltung gesteuert werden, die die Schalter (S1, S2) verriegelt und einen eigensicheren Pickup (EPU) durch Schaltsignale (tSW1, tSW2) von einer Modulatoranordnung (BMOD) bildet, die mit den Laserdioden (LD1 oder LD2) verbunden ist.

4. Eigensicherer Pickup nach Anspruch 3, bei dem in der Modulatoranordnung (BMOD) für jede Laserdiode (LD1 oder LD2) ein Modulator (MOD) vorgesehen ist, und der eine Steueranordnung (contr) aufweist, die den Modulator (MOD) einschaltet, wenn die Laserdiode (LD1, LD2), mit der er verbunden ist, betätigt wird, und wobei die Steueranordnung (contr) ein Schaltsignal (tSW) erzeugt, um die Schalter (S1, S2) mittels der logischen Schaltung zu steuern.

5. Eigensicherer Pickup nach Anspruch 1, bei dem die Steuereingänge der Schalter (S1, S2) der Schaltmittel (SW) mit Komparatoren (K1, K2) verbunden sind, die mit den Laserdioden (LD1, LD2) über eine logische Schaltung verbunden sind, die die Schalter (S1, S2) miteinander verriegelt und einen eigensicheren Pickup (EPU) bildet.

## Revendications

1. Un capteur à sécurité intrinsèque pour dispositifs de lecture ou d'enregistrement de différents supports d'enregistrement optiques ayant au moins deux diodes laser (LD1, LD2), une diode de contrôle (PD), des commutateurs (S1, S2) et des résistances pour commander différents niveaux d'intensité de lumière des diodes laser (LD1, LD2), **caractérisé en ce que**,
un moyen de commutation (SW) est fourni, est formé de commutateurs de verrouillage (S1, S2) et comprend un circuit logique afin de générer une valeur de référence qui est associée à une diode laser (LD1 ou LD2) et afin de former un capteur à sécurité intrinsèque (EPU), dans lequel ledit circuit logique empêche une fermeture simultanée des commutateurs (S1, S2) et ouvre les commutateurs (S1, S2) par une action simultanée.

2. Un capteur à sécurité intrinsèque selon la revendication 1, où le moyen de commutation (SW) comprend un circuit logique qui est formé de deux portes ET (U1, U2), chacune ayant une entrée inverseuse, et dans lequel chaque entrée inverseuse d'une porte ET (U1 ou U2, respectivement) est connectée à l'entrée de l'autre porte ET (U2 ou U1, respectivement), auquel un signal de commutation (tSW1, tSW2) est appliqué pour un des commutateurs (S1 ou S2) du moyen de commutation (SW), dont l'entrée de commande est connectée à la sortie de la porte ET (U1 ou U2) et à laquelle entrée est appliqué le signal de commutation (tSW1, tSW2) pour le commutateur (S1 ou S2).

3. Un capteur à sécurité intrinsèque selon la revendication 1, où les commutateurs (S1, S2) du moyen de commutation sont commandés via un circuit logique, qui verrouille les commutateurs (S1, S2) et forme un capteur à sécurité intrinsèque (EPU), au moyen de signaux de commutation (tSW1, tSW2) provenant d'un ensemble modulateur (BMOD) qui est connecté aux diodes laser (LD1 ou LD2).

4. Un capteur à sécurité intrinsèque selon la revendication 3, où un modulateur (MOD) est fourni dans l'ensemble modulateur (BMOD) pour chaque diode laser (LD1 ou LD2) et possède un ensemble de commande (contr) qui active le modulateur (MOD) lorsque la diode laser (LD1, LD2) auquel il est connecté est actionnée, et où l'ensemble de commande (contr) génère un signal de commutation (tSW) pour commander les commutateurs (S1, S2) au moyen du circuit logique.

5. Un capteur à sécurité intrinsèque selon la revendication 1, où les entrées de commande des commutateurs (S1, S2) du moyen de commutation (SW) sont connectées aux comparateurs (K1, K2) qui sont connectés aux diodes laser (LD1 ou LD2) via un circuit logique qui verrouille les commutateurs (S1, S2) et forme un capteur à sécurité intrinsèque (EPU).
